(19) Europäisches Patentamt
European Patent Office
Office européen des brevets

(11) **EP 3 993 073 A1**

(12) **EUROPEAN PATENT APPLICATION**
published in accordance with Art. 153(4) EPC

(43) Date of publication:
**04.05.2022  Bulletin 2022/18**

(51) International Patent Classification (IPC):
*H01L 41/18* (2006.01)   *H01L 41/047* (2006.01)
*H01L 41/053* (2006.01)   *H01L 41/33* (2013.01)
*H04R 17/00* (2006.01)

(21) Application number: 20833686.7

(22) Date of filing: **20.05.2020**

(52) Cooperative Patent Classification (CPC):
**H01L 41/183; H01L 41/047; H01L 41/053;
H01L 41/18; H01L 41/33; H04R 7/10; H04R 17/00;
H04R 31/003;** H04R 7/22; H04R 2307/025;
H04R 2307/027

(86) International application number:
**PCT/JP2020/019872**

(87) International publication number:
**WO 2020/261822 (30.12.2020 Gazette 2020/53)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority:  28.06.2019  JP 2019121515

(71) Applicant: **FUJIFILM Corporation
Tokyo 106-8620 (JP)**

(72) Inventor: **IWAMOTO, Takahiro
Minamiashigara-shi, Kanagawa 250-0193 (JP)**

(74) Representative: **Klunker IP
Patentanwälte PartG mbB
Destouchesstraße 68
80796 München (DE)**

(54) **PIEZOELECTRIC FILM**

(57)    Provided is a piezoelectric film capable of realizing an electroacoustic conversion film with an excellent heat dissipation property, in which a sufficient sound pressure with respect to an input operating voltage is obtained. The piezoelectric film is a piezoelectric film including a polymer-based piezoelectric composite material which contains piezoelectric particles in a matrix containing a polymer material, electrode layers which are laminated on both surfaces of the polymer-based piezoelectric composite material, and a protective layer laminated on a surface of at least one electrode layer, in which in a case where a cross section of the piezoelectric film is observed with a scanning electron microscope, at least one electrode layer has a plurality of projections directed toward the protective layer, and the number of projections is in a range of 2 to 40 per visual field of 85 $\mu$m in the cross section.

FIG. 1

EP 3 993 073 A1

**Description**

**BACKGROUND OF THE INVENTION**

1. Field of the Invention

The present invention relates to a piezoelectric film used for an electroacoustic conversion film or the like.

2. Description of the Related Art

With reduction in thickness and weight of displays such as liquid crystal displays or organic electroluminescence (EL) displays, speakers used in these thin displays are also required to be thinner and lighter. Further, with the development of flexible displays formed of flexible substrates such as plastics, speakers used in the flexible displays are also required to be flexible.

Examples of typical shapes of speakers of the related art include a funnel-like so-called cone shape and a spherical dome shape. However, in a case where such a speaker is intended to be incorporated in the above-described thin display, there is a concern that the lightness and the flexibility of the speaker are impaired because the speaker cannot be sufficiently made thin. Further, in a case where the speaker is attached externally, it is troublesome to carry the speaker.

Therefore, as a speaker that is thin and can be integrated into a thin display or a flexible display without impairing lightness and flexibility, a sheet-like piezoelectric film having flexibility and a property of stretching and contracting in response to an applied voltage has been suggested.

For example, a piezoelectric film (electroacoustic conversion film) disclosed in JP2014-212307A has been suggested as a sheet-like piezoelectric film that has flexibility and can stably reproduce a high-quality sound.

For example, the piezoelectric film disclosed in JP2014-212307A includes a polymer-based piezoelectric composite material obtained by dispersing piezoelectric particles in a viscoelastic matrix consisting of a polymer material having a viscoelasticity at room temperature, and electrode layers provided to sandwich the polymer-based piezoelectric composite material. The piezoelectric film described in JP2014-212307A includes a protective layer formed on the surface of a thin film electrode as a preferred aspect.

Further, in the piezoelectric film disclosed in JP2014-212307A, the area fraction of the piezoelectric particles in the polymer-based piezoelectric composite material on a contact surface with the electrode layer is 50% or less.

**SUMMARY OF THE INVENTION**

Such a piezoelectric film functions as a piezoelectric speaker by, for example, being maintained in a bent state. That is, by maintaining the piezoelectric film in a bent state and applying a driving voltage to the electrode layer, the polymer-based piezoelectric composite material stretches and contracts due to the stretch and contraction of the piezoelectric particles and the piezoelectric film vibrates to absorb the stretch and contraction. The piezoelectric film vibrates the air through this vibration and converts an electric signal into a sound.

Here, the piezoelectric film vibrates to generate heat. Therefore, it is preferable that the piezoelectric film has not only high thermoelectric conversion performance but also a satisfactory heat dissipation property.

However, the heat dissipation property of the piezoelectric film of the related art is not sufficient, and thus it is desired to realize a piezoelectric film having an excellent heat dissipation property.

The present invention has been made to solve such problems of the related art, and an object thereof is to provide a piezoelectric film capable of realizing a piezoelectric speaker in which a sufficient sound pressure with respect to an input operating voltage is obtained and the heat dissipation property is excellent, for example, in a case where the piezoelectric film is used for a piezoelectric speaker as an electroacoustic conversion film.

In order to solve the above-described problem, the present invention has the following configurations.

[1] A piezoelectric film comprising: a polymer-based piezoelectric composite material which contains piezoelectric particles in a matrix containing a polymer material; electrode layers which are provided on both surfaces of the polymer-based piezoelectric composite material; and a protective layer provided on a surface of at least one electrode layer,
in which in a case where a cross section of the piezoelectric film is observed with a scanning electron microscope, at least one electrode layer has a plurality of projections toward the protective layer, and the number of projections is in a range of 2 to 40 per visual field of 85 $\mu$m of the scanning electron microscope in a length direction of the electrode layer in the cross section.
[2] The piezoelectric film according to [1], in which the projection at an interface between the protective layer and the electrode layer has a height of 250 nm or less.

[3] The piezoelectric film according to [1] or [2], in which the projection at an interface between the protective layer and the electrode layer has a size of 2400 nm or less.

[4] The piezoelectric film according to any one of [1] to [3], in which the protective layers are provided on surfaces of both the electrode layers.

[5] The piezoelectric film according to any one of [1] to [4], in which the piezoelectric film is polarized in a thickness direction.

[6] The piezoelectric film according to any one of [1] to [5], in which the piezoelectric film has no in-plane anisotropy as a piezoelectric characteristic.

[7] The piezoelectric film according to any one of [1] to [6], in which the polymer material contains a cyanoethyl group.

[8] The piezoelectric film according to [7], in which the polymer material is cyanoethylated polyvinyl alcohol.

[9] The piezoelectric film according to any one of [1] to [8], in which the piezoelectric particles consist of ceramic particles having a perovskite-type or wurtzite-type crystal structure.

According to the present invention, for example, it is possible to provide a piezoelectric film capable of realizing a piezoelectric speaker in which a sufficient sound pressure (volume) with respect to an input operating voltage is obtained and the heat dissipation property is excellent, for example, in a case where the piezoelectric film is used for a piezoelectric speaker as an electroacoustic conversion film.

## BRIEF DESCRIPTION OF THE DRAWINGS

Fig. 1 is a cross-sectional view conceptually illustrating an example of the piezoelectric film according to the embodiment of the present invention.

Fig. 2 is a view conceptually illustrating the vicinity of a lower electrode of the piezoelectric film illustrated in Fig. 1.

Fig. 3 is a conceptual view for describing a method of measuring the size and the height of a projection of the piezoelectric film.

Fig. 4 is a conceptual view for describing a method of measuring the size and the height of a projection of the piezoelectric film.

Fig. 5 is a conceptual view for describing a method of measuring the size and the height of a projection of the piezoelectric film.

Fig. 6 is a conceptual view for describing a method of measuring the size and the height of a projection of the piezoelectric film.

Fig. 7 is a conceptual view for describing a method of producing the piezoelectric film illustrated in Fig. 1.

Fig. 8 is a conceptual view for describing a method of producing the piezoelectric film illustrated in Fig. 1.

Fig. 9 is a conceptual view for describing a method of producing the piezoelectric film illustrated in Fig. 1.

Fig. 10 is a conceptual view for describing a method of producing the piezoelectric film illustrated in Fig. 1.

Fig. 11 is a view conceptually illustrating an example of a piezoelectric speaker formed of the piezoelectric film illustrated in Fig. 1.

Fig. 12 is a conceptual view for describing a method of measuring a sound pressure.

## DESCRIPTION OF THE PREFERRED EMBODIMENTS

Hereinafter, the piezoelectric film of the present invention will be described in detail based on the preferred embodiments shown in the accompanying drawings.

Descriptions of the constituent requirements described below may be made based on representative embodiments of the present invention, but the present invention is not limited to such embodiments.

In the present specification, a numerical range shown using "to" indicates a range including numerical values described before and after "to" as a lower limit and an upper limit.

In addition, the figures shown below are conceptual views for describing the present invention, and the thickness of each layer, the size of the piezoelectric particles, the size of the constituent members, and the like are different from the actual values.

A piezoelectric film according to the embodiment of the present invention includes electrode layers on both surfaces of the polymer-based piezoelectric composite material and a protective layer on the surface of at least one electrode layer. The polymer-based piezoelectric composite material is a material containing piezoelectric particles in a matrix containing a polymer material. Further, it is preferable that the piezoelectric film according to the embodiment of the present invention further includes protective layers on the surfaces of both the electrode layers.

In a case where a cross section of such a piezoelectric film according to the embodiment of the present invention in the thickness direction is observed with a scanning electron microscope (SEM), at least one electrode layer has a plurality of projections directed toward the protective layer. Further, at least one electrode layer of the piezoelectric film according to the embodiment of the present invention has 2 to 40 projections per visual field of 85 $\mu$m (observation visual field) of the scanning electron microscope in a length direction of the electrode layer in the cross section observed with the SEM.

In the following description, the "cross section" indicates a cross section of the piezoelectric film in the thickness direction unless otherwise specified. The thickness direction of the piezoelectric film is the lamination direction of each layer.

The piezoelectric film according to the embodiment of the present invention is used, for example, as an electroacoustic conversion film. Specifically, the piezoelectric film according to the embodiment of the present invention is used as a vibration plate of an electroacoustic converter such as a piezoelectric speaker, a microphone, or a voice sensor.

In an electroacoustic converter, in a case where the piezoelectric film is stretched in the in-plane direction due to application of a voltage to the piezoelectric film, the piezoelectric film moves upward (in the radiation direction of the sound) in order to absorb the stretched part. On the contrary, in a case where the piezoelectric film is contracted in the in-plane direction due to application of a voltage to the piezoelectric film, the piezoelectric film moves downward in order to absorb the contracted part.

The electroacoustic converter converts vibration (sound) and an electric signal using vibration caused by repeated stretch and contraction of the piezoelectric film. Such an electroacoustic converter inputs an electric signal to the piezoelectric film to reproduce a sound due to the vibration in response to the electric signal and converts the vibration of the piezoelectric film to an electric signal by receiving a sound wave. Further, the piezoelectric film can be used to apply tactile sensation or transport an object through the vibration.

Specifically, the applications of piezoelectric film include speakers such as full-range speakers, tweeters, squawkers, and woofers, speakers for headphones, noise cancellers, microphones, and pickups (sensors for musical instruments) used for musical instruments such as guitars. Further, the piezoelectric film according to the embodiment of the present invention is a non-magnetic material, and thus can be suitably used as a noise canceller for MRI among noise cancellers.

Further, the electroacoustic converter formed of the piezoelectric film according to the embodiment of the present invention is thin, light, and bendable, and thus can be suitably used as wearable products such as hats, mufflers, and clothes, thin displays such as televisions and digital signage, buildings having a function as an acoustic device, ceilings of automobiles, curtains, umbrellas, wallpaper, windows, beds, and the like.

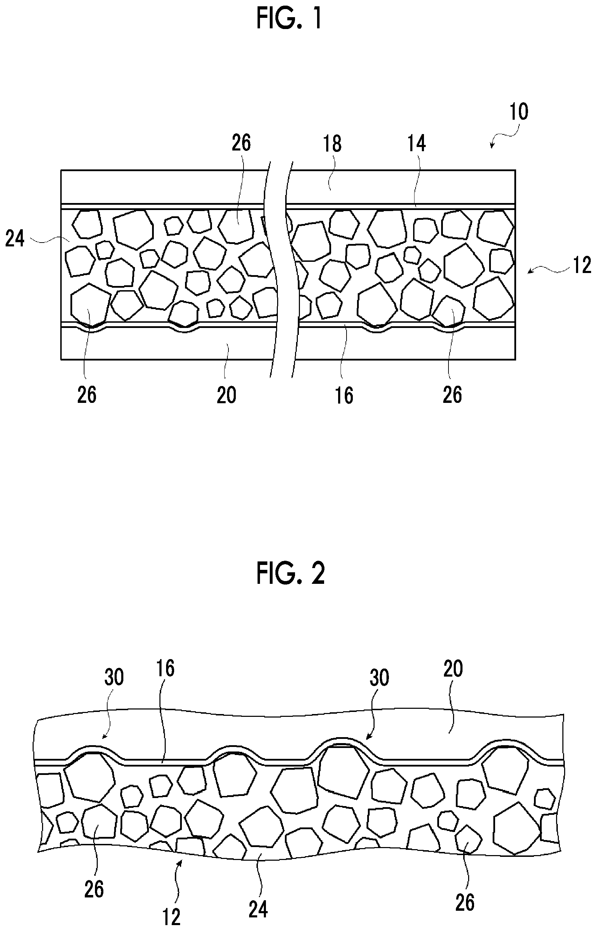

Fig. 1 is a cross-sectional view conceptually illustrating an example of the piezoelectric film according to the embodiment of the present invention.

A piezoelectric film 10 illustrated in Fig. 1 includes a piezoelectric layer 12, an upper thin film electrode 14 laminated on one surface of the piezoelectric layer 12, an upper protective layer 18 laminated on the upper thin film electrode 14, a lower thin film electrode 16 laminated on the other surface of the piezoelectric layer 12, and a lower protective layer 20 laminated on the lower thin film electrode 16.

In the piezoelectric film 10, the piezoelectric layer 12 contains piezoelectric particles 26 in a polymer matrix 24 containing a polymer material, as conceptually illustrated in Fig. 1. That is, the piezoelectric layer 12 is a polymer-based piezoelectric composite material in the piezoelectric film according to the embodiment of the present invention.

Here, it is preferable that the polymer-based piezoelectric composite material (piezoelectric layer 12) satisfies the following requirements. Further, in the present invention, room temperature is in a range of 0°C to 50°C.

(i) Flexibility

For example, in a case of being gripped in a state of being loosely bent like a document such as a newspaper or a magazine as a portable device, the piezoelectric film is continuously subjected to large bending deformation from the outside at a relatively slow vibration of less than or equal to a few Hz. In this case, in a case where the polymer-based piezoelectric composite material is hard, a large bending stress is generated to that extent, and a crack is generated at the interface between a polymer matrix and piezoelectric particles, which may lead to breakage. Accordingly, the polymer-based piezoelectric composite material is required to have suitable flexibility. In addition, in a case where strain energy is diffused into the outside as heat, the stress is able to be relieved. Therefore, the polymer-based piezoelectric composite material is required to have a suitably large loss tangent.

(ii) Acoustic quality

In a speaker, the piezoelectric particles vibrate at a frequency of an audio band of 20 Hz to 20 kHz, and the vibration energy causes the entire vibration plate (polymer-based piezoelectric composite material) to vibrate integrally so that a sound is reproduced. Therefore, in order to increase the transmission efficiency of the vibration energy, the polymer-based piezoelectric composite material is required to have appropriate hardness. In addition, in a case where the frequencies of the speaker are smooth as the frequency characteristic thereof, an amount of change in acoustic quality in a case where the lowest resonance frequency $f_0$ is changed in association with a change in the curvature of the speaker decreases. Therefore, the loss tangent of the polymer-based piezoelectric composite material is required to be suitably large.

It is known that the lowest resonance frequency $f_0$ of the vibration plate for a speaker is represented by the following equation. Here, s represents the stiffness of the vibration system and m represents the mass.

$$\text{Lowest resonance frequency}: \quad f_0 = \frac{1}{2\pi}\sqrt{\frac{s}{m}}$$

Here, as the degree of curvature of the piezoelectric film, that is, the radius of curvature of the curved portion increases, the mechanical stiffness s decreases, and thus the lowest resonance frequency $f_0$ decreases. That is, the acoustic quality (the volume and the frequency characteristics) of the speaker changes depending on the radius of curvature of the piezoelectric film.

That is, the polymer-based piezoelectric composite material is required to exhibit a behavior of being rigid with respect to a vibration of 20 Hz to 20 kHz and being flexible with respect to a vibration of less than or equal to a few Hz. In addition, the loss tangent of a polymer-based piezoelectric composite material is required to be suitably large with respect to the vibration of all frequencies of 20 kHz or less.

In general, a polymer solid has a viscoelasticity relieving mechanism, and a molecular movement having a large scale is observed as a decrease (relief) in a storage elastic modulus (Young's modulus) or a maximal value (absorption) in a loss elastic modulus along with an increase in temperature or a decrease in frequency. Among these, the relief due to a microbrown movement of a molecular chain in an amorphous region is referred to as main dispersion, and an extremely large relieving phenomenon is observed. A temperature at which this main dispersion occurs is a glass transition point (Tg), and the viscoelasticity relieving mechanism is most remarkably observed.

In the polymer-based piezoelectric composite material (piezoelectric layer 12), the polymer-based piezoelectric composite material exhibiting a behavior of being rigid with respect to a vibration of 20 Hz to 20 kHz and being flexible with respect to a vibration of less than or equal to a few Hz is realized by using a polymer material whose glass transition point is room temperature, that is, a polymer material having a viscoelasticity at room temperature as a matrix. In particular, from the viewpoint that such a behavior is suitably exhibited, it is preferable that the polymer material in which the glass transition temperature at a frequency of 1 Hz is at room temperature is used for a matrix of the polymer-based piezoelectric composite material.

In the polymer material, it is preferable that the maximal value of a loss tangent Tanδ at a frequency of 1 Hz according to a dynamic viscoelasticity test at room temperature is 0.5 or greater.

In this manner, in a case where the polymer-based piezoelectric composite material is slowly bent due to an external force, stress concentration on the interface between the polymer matrix and the piezoelectric particles at the maximum bending moment portion is relieved, and thus satisfactory flexibility can be expected.

In the polymer material, it is preferable that a storage elastic modulus (E') at a frequency of 1 Hz according to the dynamic viscoelasticity measurement is 100 MPa or greater at 0°C and 10 MPa or less at 50°C.

In this manner, the bending moment generated in a case where the polymer-based piezoelectric composite material is slowly bent due to the external force can be reduced, and the polymer-based piezoelectric composite material can exhibit a behavior of being rigid with respect to an acoustic vibration of 20 Hz to 20 kHz.

In addition, it is more suitable that the relative dielectric constant of the polymer material is 10 or greater at 25°C. Accordingly, in a case where a voltage is applied to the polymer-based piezoelectric composite material, a higher electric field is applied to the piezoelectric particles in the polymer matrix, and thus a large deformation amount can be expected.

However, in consideration of ensuring satisfactory moisture resistance and the like, it is suitable that the relative dielectric constant of the polymer material is 10 or less at 25°C.

Suitable examples of the polymer material that satisfies such conditions include cyanoethylated polyvinyl alcohol (cyanoethylated PVA), polyvinyl acetate, polyvinylidene chloride-co-acrylonitrile, a polystyrene-vinyl polyisoprene block copolymer, polyvinyl methyl ketone, and polybutyl methacrylate.

In addition, as these polymer materials, a commercially available product such as Hybrar 5127 (manufactured by Kuraray Co., Ltd.) can be suitably used.

Among these, it is preferable to use a polymer material containing a cyanoethyl group and particularly preferable to use cyanoethylated PVA as the polymer material constituting the polymer matrix 24. That is, in the piezoelectric film 10 according to the embodiment of the present invention, it is preferable to use a polymer material containing a cyanoethyl group and particularly preferable to use cyanoethylated PVA as the polymer matrix 24 of the piezoelectric layer 12.

In the description below, the above-described polymer materials typified by cyanoethylated PVA will also be collectively referred to as the "polymer material having a viscoelasticity at room temperature".

Further, the polymer material having a viscoelasticity at room temperature may be used alone or in combination (mixture) of two or more kinds thereof.

In the piezoelectric film 10 according to the embodiment of the present invention, a plurality of polymer materials may be used in combination as necessary for the polymer matrix 24 of the piezoelectric layer 12.

That is, for the purpose of adjusting dielectric characteristics, mechanical characteristics, and the like, other dielectric polymer materials may be added to the polymer matrix 24 constituting the polymer-based piezoelectric composite material in addition to the polymer material having a viscoelasticity at room temperature as necessary.

Examples of the dielectric polymer material that can be added thereto include a fluorine-based polymer such as polyvinylidene fluoride, a vinylidene fluoride-tetrafluoroethylene copolymer, a vinylidene fluoride-trifluoroethylene copolymer, a polyvinylidene fluoride-trifluoroethylene copolymer, or a polyvinylidene fluoride-tetrafluoroethylene copolymer, a polymer containing a cyano group or a cyanoethyl group such as a vinylidene cyanide-vinyl acetate copolymer, cyanoethyl cellulose, cyanoethyl hydroxysaccharose, cyanoethyl hydroxycellulose, cyanoethyl hydroxypullulan, cyanoethyl methacrylate, cyanoethyl acrylate, cyanoethyl hydroxyethyl cellulose, cyanoethyl amylose, cyanoethyl hydroxypropyl cellulose, cyanoethyl dihydroxypropyl cellulose, cyanoethyl hydroxypropyl amylose, cyanoethyl polyacrylamide, cyanoethyl polyacrylate, cyanoethyl pullulan, cyanoethyl polyhydroxymethylene, cyanoethyl glycidol pullulan, cyanoethyl saccharose, or cyanoethyl sorbitol, and synthetic rubber such as nitrile rubber or chloroprene rubber.

Among these, a polymer material containing a cyanoethyl group is suitably used.

Further, in the polymer matrix 24 of the piezoelectric layer 12, the number of these dielectric polymer materials is not limited to one, and a plurality of kinds of dielectric polymer materials may be added.

In addition, for the purpose of adjusting the glass transition point Tg of the polymer matrix 24, the polymer matrix 24 may contain a thermoplastic resin such as a vinyl chloride resin, polyethylene, polystyrene, a methacrylic resin, polybutene, or isobutylene, and a thermosetting resin such as a phenol resin, a urea resin, a melamine resin, an alkyd resin, or mica in addition to the dielectric polymer materials.

Further, for the purpose of improving the pressure sensitive adhesiveness, a viscosity imparting agent such as rosin ester, rosin, terpene, terpene phenol, or a petroleum resin may be added.

In the polymer matrix 24 of the piezoelectric layer 12, the addition amount in a case of adding polymer materials other than the polymer material having a viscoelasticity at room temperature is not particularly limited, but is preferably set to 30% by mass or less in terms of the proportion of the polymer materials in the matrix 24.

In this manner, the characteristics of the polymer material to be added can be exhibited without impairing the viscoelasticity relieving mechanism in the polymer matrix 24, and thus preferable results, for example, an increase in the dielectric constant, improvement of the heat resistant, and improvement of the adhesiveness between the piezoelectric particles 26 and the electrode layer can be obtained.

The piezoelectric layer 12 (polymer-based piezoelectric composite material) contains the piezoelectric particles 26 in the polymer matrix.

It is preferable that the piezoelectric particles 26 consist of ceramic particles having a perovskite type or wurtzite type crystal structure.

Examples of the ceramic particles constituting the piezoelectric particles 26 include lead zirconate titanate (PZT), lead lanthanum zirconate titanate (PLZT), barium titanate (BaTiOs), zinc oxide (ZnO), and a solid solution (BFBT) of barium titanate and bismuth ferrite ($BiFe_3$).

The particle diameter of the piezoelectric particles 26 may be appropriately selected according to the size and the applications of the piezoelectric film 10. The particle diameter of the piezoelectric particles 26 is preferably in a range of 1 to 10 $\mu$m.

By setting the particle diameter of the piezoelectric particles 26 to be in the above-described range, preferable results in terms of achieving both excellent piezoelectric characteristics and flexibility can be obtained.

In the piezoelectric film 10, the ratio between the amount of the polymer matrix 24 and the amount of the piezoelectric particles 26 in the piezoelectric layer 12 may be appropriately set according to the size and the thickness of the piezoelectric film 10 in the plane direction, the applications of the piezoelectric film 10, the characteristics required for the piezoelectric film 10, and the like.

The volume fraction of the piezoelectric particles 26 in the piezoelectric layer 12 is preferably in a range of 30% to 80% and more preferably in a range of 50% to 80%.

By setting the ratio between the amount of the polymer matrix 24 and the amount of the piezoelectric particles 26 to be in the above-described range, preferable results in terms of achieving both of excellent piezoelectric characteristics and flexibility can be obtained.

In the piezoelectric film 10, the thickness of the piezoelectric layer 12 is not limited and may be appropriately set according to the size of the piezoelectric film 10, the applications of the piezoelectric film 10, the characteristics required for the piezoelectric film 10, and the like.

The thickness of the piezoelectric layer 12 is preferably in a range of 8 to 300 $\mu$m, more preferably in a range of 8 to 200 $\mu$m, still more preferably in a range of 10 to 150 $\mu$m, and particularly preferably in a range of 15 to 100 $\mu$m.

By setting the thickness of the piezoelectric layer 12 to be in the above-described range, preferable results in terms of achieving both ensuring of the rigidity and moderate elasticity can be obtained.

It is preferable that the piezoelectric layer 12 is subjected to a polarization treatment (poling) in the thickness direction. The polarization treatment will be described in detail later.

The piezoelectric film 10 illustrated in Fig. 1 has a configuration in which the lower thin film electrode 16 is provided on one surface of the piezoelectric layer 12, the lower protective layer 20 is provided on the lower thin film electrode 16 as a preferred embodiment, the upper thin film electrode 14 is provided on the other surface of the piezoelectric layer 12, and the upper protective layer 18 is provided on the upper thin film electrode 14 as a preferred embodiment. In the piezoelectric film 10, the upper thin film electrode 14 and the lower thin film electrode 16 form an electrode pair.

That is, the piezoelectric film 10 according to the embodiment of the present invention has a configuration in which both surfaces of the piezoelectric layer 12 are sandwiched between the electrode pair, that is, the upper thin film electrode 14 and the lower thin film electrode 16 and preferably between the upper protective layer 18 and the lower protective layer 20.

The region sandwiched between the upper thin film electrode 14 and the lower thin film electrode 16 is driven according to the applied voltage.

In the present invention, the terms "upper" and "lower" in the lower thin film electrode 16 and the lower protective layer 20, and the upper thin film electrode 14 and the upper protective layer 18 are provided based on the accompanying drawings for convenience in order to describe the piezoelectric film 10 according to the embodiment of the present invention.

Therefore, the terms "upper" and "lower" in the piezoelectric film 10 according to the embodiment of the present invention have no technical meaning and are irrelevant to the actual use state.

Further, the piezoelectric film 10 according to the embodiment of the present invention may further include a bonding layer for bonding the thin film electrode and the piezoelectric layer 12 to each other and a bonding layer for bonding the thin film electrode and the protective layer to each other, in addition to the above-described layers.

The bonding agent may be an adhesive or a pressure sensitive adhesive. Further, the same material as the polymer material obtained by removing the piezoelectric particles 26 from the piezoelectric layer 12, that is, the polymer matrix 24 can also be suitably used as the bonding agent. Further, the bonding layer may be provided on both the upper thin film electrode 14 side and the lower thin film electrode 16 side or may be provided on only one of the upper thin film electrode 14 side or the lower thin film electrode 16 side.

Further, the piezoelectric film 10 may further include an electrode lead portion that leads out the electrodes from the upper thin film electrode 14 and the lower thin film electrode 16, and an insulating layer which covers a region where the piezoelectric layer 12 is exposed for preventing a short circuit or the like, in addition to the above-described layers.

The electrode lead portion may be configured such that a portion where the thin film electrode and the protective layer project convexly outside the piezoelectric layer in the plane direction is provided or configured such that a part of the protective layer is removed to form a hole portion, and a conductive material such as silver paste is inserted into the hole portion so that the conductive material is conducted with the thin film electrode.

Each thin film electrode may have only one or two or more electrode lead portions. Particularly in a case of the configuration in which the electrode lead portion is obtained by removing a part of the protective layer and inserting a conductive material into the hole portion, it is preferable that the thin film electrode has three or more electrode lead portions in order to more reliably ensure the conduction.

The upper protective layer 18 and the lower protective layer 20 in the piezoelectric film 10 have a function of covering the upper thin film electrode 14 and the lower thin film electrode 16 and applying moderate rigidity and mechanical strength to the piezoelectric layer 12. That is, in the piezoelectric film 10 according to the embodiment of the present invention, the piezoelectric layer 12 containing the polymer matrix 24 and the piezoelectric particles 26 exhibits extremely excellent flexibility under bending deformation at a slow vibration, but may have insufficient rigidity or mechanical strength depending on the applications. As a compensation for this, the piezoelectric film 10 is provided with the upper protective layer 18 and the lower protective layer 20.

The lower protective layer 20 and the upper protective layer 18 have the same configuration except for the disposition position. Therefore, in the description below, in a case where it is not necessary to distinguish the lower protective layer 20 from the upper protective layer 18, both members are collectively referred to as a protective layer.

According to a more preferred embodiment, the piezoelectric film 10 in the example illustrated in the figure has the lower protective layer 20 and the upper protective layer 18 in a manner of being laminated on both thin film electrodes.

However, the present invention is not limited thereto, and a configuration having only one of the lower protective layer 20 or the upper protective layer 18 may be employed.

The protective layer is not limited, and various sheet-like materials can be used as the protective layer, and suitable examples thereof include various resin films. Among these, from the viewpoints of excellent mechanical characteristics and heat resistance, a resin film consisting of polyethylene terephthalate (PET), polypropylene (PP), polystyrene (PS), polycarbonate (PC), polyphenylene sulfide (PPS), polymethylmethacrylate (PMMA), polyetherimide (PEI), polyimide (PI), polyamide (PA), polyethylene naphthalate (PEN), triacetyl cellulose (TAC), and a cyclic olefin-based resin is suitably used.

The thickness of the protective layer is not limited. In addition, the thicknesses of the upper protective layer 18 and the lower protective layer 20 are basically the same as each other, but may be different from each other.

Here, in a case where the rigidity of the protective layer is extremely high, not only is the stretch and contraction of the piezoelectric layer 12 constrained, but also the flexibility is impaired. Therefore, it is advantageous that the thickness of the protective layer decrease except for the case where the mechanical strength or excellent handleability as a sheet-like material is required.

Based on the examination conducted by the present inventors, in a case where the thickness of the upper protective layer 18 and the thickness of the lower protective layer 20 are respectively two times or less the thickness of the piezoelectric layer 12, preferable results in terms of achieving both ensuring of the rigidity and moderate elasticity can be obtained.

For example, in a case where the thickness of the piezoelectric layer 12 is 50 $\mu$m and the lower protective layer 20 and the upper protective layer 18 consist of PET, the thickness of the lower protective layer 20 and the thickness of the upper protective layer 18 are respectively preferably 100 $\mu$m or less, more preferably 50 $\mu$m or less, and still more preferably 25 $\mu$m or less.

In the piezoelectric film 10, the upper thin film electrode 14 is formed between the piezoelectric layer 12 and the upper protective layer 18, and the lower thin film electrode 16 is formed between the piezoelectric layer 12 and the lower protective layer 20. In the description below, the upper thin film electrode 14 is also referred to as an upper electrode 14, and the lower thin film electrode 16 is also referred to as a lower electrode 16.

The upper electrode 14 and the lower electrode 16 are provided to apply an electric field to the piezoelectric film 10 (piezoelectric layer 12).

Further, the lower electrode 16 and the upper electrode 14 are basically the same as each other. Therefore, in the description below, in a case where it is not necessary to distinguish the lower electrode 16 from the upper electrode 14, both members are collectively referred to as a thin film electrode.

In the piezoelectric film according to the embodiment of the present invention, the material for forming the thin film electrode is not limited, and various conductors can be used as the material. Specific examples thereof include conductive polymers such as carbon, palladium, iron, tin, aluminum, nickel, platinum, gold, silver, copper, chromium, molybdenum, alloys thereof, indium tin oxide, and polyethylene dioxythiophene-polystyrene sulfonic acid (PEDOT/PPS).

Among these, copper, aluminum, gold, silver, platinum, and indium tin oxide are suitable. Among these, from the viewpoints of the conductivity, the cost, and the flexibility, copper is more preferable.

In addition, the method of forming the thin film electrode is not limited, and various known methods, for example, a film forming method such as a vapor-phase deposition method (a vacuum film forming method) such as vacuum vapor deposition or sputtering, a film forming method using plating, a method of bonding a foil formed of the materials described above, and a coating method can be used.

Among these, particularly from the viewpoint of ensuring the flexibility of the piezoelectric film 10, a thin film made of copper, aluminum, or the like formed by vacuum vapor deposition is suitably used as the thin film electrode. Among these, particularly a thin film made of copper formed by vacuum vapor deposition is suitably used.

The thickness of the upper electrode 14 and the lower electrode 16 is not limited. In addition, the thicknesses of the upper electrode 14 and the lower electrode 16 may be basically the same as or different from each other.

Here, similarly to the protective layer described above, in a case where the rigidity of the thin film electrode is extremely high, not only is the stretch and contraction of the piezoelectric layer 12 constrained, but also the flexibility is impaired. Therefore, it is advantageous that the thicknesses of the thin film electrode decreases in a case where the electrical resistance is not excessively high.

It is suitable that the product of the thicknesses of the thin film electrode of the piezoelectric film 10 according to the embodiment of the present invention and the Young's modulus thereof is less than the product of the thickness of the protective layer and the Young's modulus thereof because the flexibility is not considerably impaired.

For example, in a case of a combination consisting of the protective layer formed of PET (Young's modulus: approximately 6.2 GPa) and the thin film electrode formed of copper (Young's modulus: approximately 130 GPa), the thickness of the thin film electrode is preferably 1.2 $\mu$m or less, more preferably 0.3 $\mu$m or less, and still more preferably 0.1 $\mu$m or less in a case of assuming that the thickness of the protective layer is 25 $\mu$m.

As described above, the piezoelectric film 10 has a configuration in which the piezoelectric layer 12 containing the piezoelectric particles 26 in the polymer matrix 24 containing the polymer material is sandwiched between the upper electrode 14 and the lower electrode 16 and the laminate is further sandwiched between the upper protective layer 18 and the lower protective layer 20.

It is preferable that, in such a piezoelectric film 10, the maximal value at which the loss tangent (tan$\delta$) at a frequency of 1 Hz according to dynamic viscoelasticity measurement is 0.1 or greater is present at room temperature.

In this manner, even in a case where the piezoelectric film 10 is subjected to bending deformation at a slow vibration of less than or equal to a few Hz from the outside, since the strain energy can be effectively diffused to the outside as heat, occurrence of cracks on the interface between the polymer matrix and the piezoelectric particles can be prevented.

In the piezoelectric film 10, it is preferable that the storage elastic modulus (E') at a frequency of 1 Hz according to the dynamic viscoelasticity measurement is 10 to 30 GPa at 0°C and 1 to 10 GPa at 50°C.

In this manner, the piezoelectric film 10 may have large frequency dispersion in the storage elastic modulus (E') at room temperature. That is, the piezoelectric film 10 can exhibit a behavior of being rigid with respect to a vibration of 20 Hz to 20 kHz and being flexible with respect to a vibration of less than or equal to a few Hz.

In the piezoelectric film 10, it is preferable that the product of the thickness and the storage elastic modulus (E') at a frequency of 1 Hz according to the dynamic viscoelasticity measurement is in a range of $1.0 \times 10^6$ to $2.0 \times 10^6$ N/m at 0°C and in a range of $1.0 \times 10^5$ to $1.0 \times 10^6$ N/m at 50°C.

In this manner, the piezoelectric film 10 may have moderate rigidity and mechanical strength within a range not impairing the flexibility and the acoustic characteristics.

Further, in the piezoelectric film 10, it is preferable that the loss tangent (Tan$\delta$) at a frequency of 1 kHz at 25°C is 0.05 or greater in a master curve obtained from the dynamic viscoelasticity measurement.

In this manner, the frequency of a speaker using the piezoelectric film 10 is smooth as the frequency characteristic thereof, and thus a change in acoustic quality in a case where the lowest resonance frequency $f_0$ is changed according to a change in the curvature of the speaker (piezoelectric film 10) can be decreased.

As described above, in the piezoelectric film according to the embodiment of the present invention, at least one of the upper electrode or the lower electrode has a plurality of projections directed toward the adjacent protective layer in a case where a cross section is observed by a SEM. Further, in the piezoelectric film according to the embodiment of the present invention, at least one of the upper electrode and the lower electrode has 2 to 40 projections per visual field of 85 $\mu$m in the length direction of the electrode layer (the upper electrode 14 and the lower electrode 16) in the SEM image of the cross section observed by the SEM.

In the piezoelectric film 10 of the example illustrated in the figure, the lower electrode 16 has 2 to 40 projections directed toward the lower protective layer 20 per visual field of 85 $\mu$m in the length direction of the electrode layer in the SEM image of the cross section observed by the SEM. Further, in the piezoelectric film 10 of the example illustrated in the figure, the upper electrode 14 does not have projections protruding toward the upper protective layer 18 and is basically flat even in a case where the upper electrode has large unevenness such as waviness caused by fluctuation in the thickness of the piezoelectric layer 12.

Fig. 2 conceptually illustrates a partially enlarged state of the cross section of the piezoelectric film 10.

Fig. 2 is a view conceptually illustrating the vicinity of the lower electrode 16. Further, the up and down directions in Fig. 2 are opposite to the directions in Fig. 1. That is, in Fig. 2, the lower protective layer 20, the lower electrode 16, and the piezoelectric layer 12 are illustrated in this order from the top in the figure.

As illustrated in Fig. 2, the lower electrode 16 has projections 30 which are rising portions in a convex shape protruding toward the lower protective layer 20 side caused by the piezoelectric particles 26 of the piezoelectric layer 12. Therefore, the lower protective layer 20 is recessed (concave shape) to form recesses corresponding to the projections 30 at the positions of the projections 30 of the lower electrode 16.

That is, in the piezoelectric film 10, projections 30 which are rising portions of the lower electrode 16, formed by the pressure of the piezoelectric particles 26 more protruding toward the lower protective layer 20 side with respect to other piezoelectric particles 26 and recesses of the lower protective layer 20 corresponding to the projections 30 are present at the same positions on the lower electrode 16 side.

Such projections 30 of the lower electrode 16 (electrode layer) can be observed and confirmed by observing the cross section of the piezoelectric film 10 with a SEM. As described above, the cross section is a cross section of the piezoelectric film 10 in the thickness direction.

Further, the piezoelectric film 10 observed by a SEM may be cut by a known method. Suitable examples of the known method include a method of cutting the film using an ion milling method (ion milling device).

Further, the cutting of the piezoelectric film 10 and the observation with a SEM described later may be performed by adhering the piezoelectric film 10 to a support with an adhesive, as necessary. Preferred examples of the support include a sheet-like material having a thickness of several to several tens of micrometers and a smooth surface. The material for forming the support is not limited, and suitable examples thereof include metals, glass, and resins. The adhesive is not limited, and various known adhesives can be used as long as the surface of the piezoelectric film 10 is not affected by the adhesive. The thickness of the adhesive may be approximately in a range of 10 to several tens of micrometers.

Further, in a case where a cross section of the piezoelectric film 10 is observed with a SEM, the film may be subjected to a known conductive treatment such as Os coating (osmium coating), which is performed in observation of a sample with a SEM as necessary.

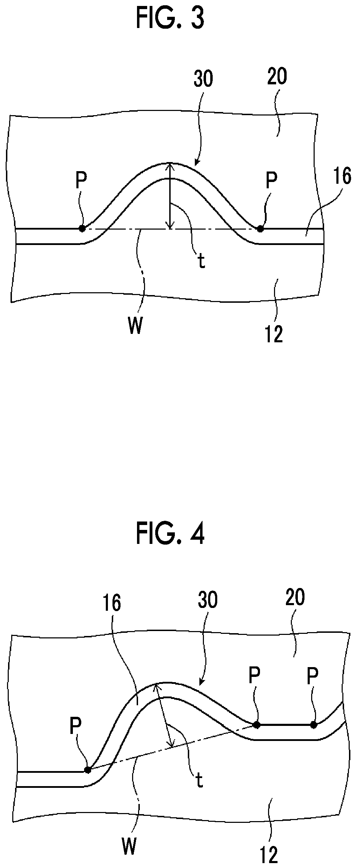

Fig. 3 conceptually illustrates an example of the projection 30 (a rising portion of the lower electrode 16). Further, in Fig. 3 and Figs. 4 to 6 described later, the piezoelectric particles 26 in the piezoelectric layer 12 are omitted in order to simplify the drawings and clarify the description.

In the piezoelectric film 10 according to the embodiment of the present invention, as illustrated in Figs. 2 and 3, the projection 30 of the lower electrode 16 is basically formed by rising toward the lower protective layer 20 side from the flat portion of the lower electrode 16 by the pressure of the piezoelectric particles 26. That is, the surface of the flat portion in Figs. 2 and 3 is the original surface of the lower electrode 16. Further, the surface of the lower electrode 16 is the surface of the lower electrode 16 on the lower protective layer 20 side.

Specifically, the projection 30 of the lower electrode 16 protrudes from a certain position of the flat portion of the lower electrode 16 in the cross section of the piezoelectric film 10 in the length direction of the electrode layer, ascends toward the lower protective layer 20 side, reaches the vertex at a certain position, starts descending toward the piezoelectric layer 12 side, and is formed into a flat portion of the lower electrode 16 again.

Further, the length direction of the electrode layer is the length direction of the upper electrode 14 and the lower electrode 16 in the cross section of the piezoelectric film 10, that is, the lateral direction in the figure. The length direction of the electrode layer coincides with the plane direction of the main surface (maximum surface) of the piezoelectric film.

As illustrated in Fig. 3, the position where the surface of the lower electrode 16 starts to rise toward the lower protective layer 20 in the length direction of the electrode layer at the interface between the lower electrode 16 and the lower protective layer 20 in the cross section of the piezoelectric film 10 is defined as a reference point P. Further, the line (dashed line) connecting the reference points P is defined as a reference line W. In the piezoelectric film 10 according to the embodiment of the present invention, the length of the reference line W is defined as the size of the projection 30.

Further, a perpendicular line t is set up from the reference line W, and the length of the perpendicular line t having the longest length from the reference line W to the surface of the lower electrode 16 is defined as the height of the projection 30.

In the piezoelectric film 10 according to the embodiment of the present invention, the projection 30 may not necessarily rise from the original surface of the lower electrode 16.

For example, in a case where the distance between the projections 30 is short, the projections 30 do not rise from the original surface of the lower electrode 16, a flat portion between the projections 30 with a constant height of the lower electrode 16 is formed, and the projections 30 adjacent to each other may rise from the flat portion as conceptually illustrated in Fig. 4.

In this case, as illustrated in Fig. 4, the rising point from the flat portion with a constant height of the lower electrode 16 is defined as the reference point P, the reference line W and the perpendicular line t are set by connecting the reference points P, and the size of the projection 30 and the height of the projection 30 may be measured.

Further, the constant height of the lower electrode 16, that is, the flat portion of the lower electrode 16 indicates that the distance between the lower electrode 16 and the main surface of the piezoelectric film 10 on a side opposite to the lower electrode 16, that is, the surface of the upper protective layer 18 is constant.

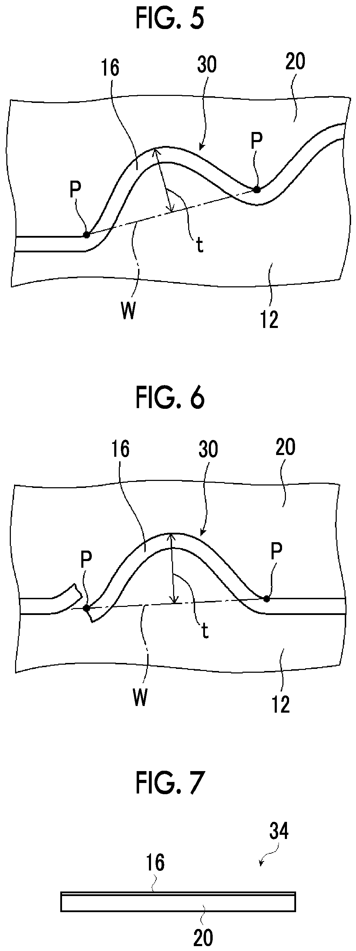

Further, in a case where the distance between the projections 30 is shorter, the surface of the lower electrode 16 descending toward the piezoelectric layer 12 in the length direction of the electrode layer may rise and ascends toward the lower protective layer 20 without being flat between the projections 30 as conceptually illustrated in Fig. 5.

In this case, as illustrated in Fig. 5, the point where the surface of the lower electrode 16 turns from descending to ascending, that is, the bottom of the surface of the lower electrode 16 is defined as the reference point P, the reference line W and the perpendicular line t are set by connecting the reference points P, and the size of the projection 30 and the height of the projection 30 may be measured.

Depending on the distance between the adjacent projections 30, the shape of the projection 30 may be a shape having a so-called shoulder that descends toward the piezoelectric layer 12 again after the lower electrode 16 is flattened between the projections 30 as illustrated in Fig. 4.

In this case, the shoulder portion is also regarded as a part of the projection 30, and the position where the lower electrode 16 starts to ascend (rise) toward the lower protective layer 20 in the length direction of the electrode layer is defined as the reference point P, and the size of the projection 30 and the height of the projection 30 may be measured in the same manner as in the examples illustrated in Figs. 4 and 5.

As will be described later, the projections 30 of the lower electrode 16 can be formed, for example, by performing the calender treatment on the piezoelectric layer 12 a plurality of times during the production of the piezoelectric film 10. That is, by performing the calender treatment on the piezoelectric layer 12 a plurality of times, the piezoelectric particles 26 strongly press the lower electrode 16, and as a result, the projections 30 can be formed on the lower electrode 16.

Therefore, in the cross section of the piezoelectric film 10, the lower electrode 16 may be fractured at the projections 30, as conceptually illustrated in Fig. 6.

Here, in a case where a step of the lower electrode 16 at the fractured portion (fractured position) is large, the fractured portion is defined as the reference point P, the reference line W and the perpendicular line t are set by connecting the reference points P, and the size of the projection 30 and the height of the projection 30 may be measured as illustrated in Fig. 6.

In the piezoelectric film 10, the large step of the lower electrode 16 at the fractured portion specifically indicates that the size of the step of the lower electrode 16 at the fractured portion in the thickness direction is 100 nm or greater. Therefore, in a case where the size of the step of the fractured portion in the thickness direction is less than 100 nm, it is considered that the lower electrode 16 is not fractured, and the reference line W is set and the size of the projection 30 and the height of the projection 30 may be set in the same manner as described above.

The height and the size of the projection 30 may be measured, for example, by imaging a cross section of the piezoelectric film 10 with a SEM and analyzing the image at a magnification of 40000 times.

In the present invention, as described above, a rising portion of the lower electrode 16 (electrode layer) which is formed by the pressure of the piezoelectric particles 26 more protruding toward the lower protective layer 20 side with respect to other piezoelectric particles 26, is present at the same position as the recess of the lower protective layer 20, and is directed toward the lower protective layer 20 is defined as the projection 30.

It is preferable that rising portions having a height of 20 nm or greater, measured as described above, are defined as the projections 30 from among the rising portions of the lower electrode 16 which are directed toward the lower protective layer 20.

In the piezoelectric film 10 according to the embodiment of the present invention, the lower electrode 16 has 2 to 40 projections 30 per visual field of 85 $\mu$m in the length direction of the electrode layer in the SEM image of the cross section. As described above, the cross section is a cross section of the piezoelectric film 10 in the thickness direction, and the length direction of the electrode layer is the length direction of the upper electrode 14 and the lower electrode 16 in the SEM image of the cross section. The length direction of the electrode layer is the lateral direction in Figs. 1 to 6. It is preferable that the piezoelectric film 10 according to the embodiment of the present invention has 2 to 40 projections 30 having a height of 20 nm or greater per visual field of 85 $\mu$m in the length direction of the electrode layer in the SEM image of the cross section.

In the present invention, the number of the projections 30 per visual field of 85 $\mu$m in the length direction of the electrode layer in the SEM image may be counted in a visual field of 85 $\mu$m in the length direction of any electrode layer in the SEM image in the cross section of the piezoelectric film 10. The observation magnification of the SEM in a case of counting the number of projections 30 may be set to, for example, 1500 times. Further, in a case where the height, the size, and the like of the projection 30 are measured, the magnification is set to, for example, 40000 times as described above.

The cross section of the piezoelectric film 10 may be observed by capturing a cross-sectional SEM image at 1500 times to count the number of the projections 30, enlarging the site of the projections 30 at 40000 times, and measuring the height and the like of the projections. Alternatively, the cross-sectional SEM image is captured at 1500 times to count the number of the projections 30, the cross-sectional SEM image at the site of the projections 30 is captured at 40000 times and the height and the like of the projections are measured.

In the present invention, the number of the projections 30 per visual field of 85 $\mu$m in the length direction of the electrode layer of the SEM image in the cross section of the piezoelectric film 10 is counted on any ten cross sections of the piezoelectric film 10. Further, the average value of the numbers of the projections 30 in ten cross sections is calculated, and the average value is defined as the number of projections 30 per visual field of 85 $\mu$m in the length direction of the electrode layer in the SEM image of the cross section of the piezoelectric film 10.

With such a configuration, in a case where the piezoelectric film 10 according to the embodiment of the present invention is used for a piezoelectric speaker as a electroacoustic conversion film, a piezoelectric speaker in which a sufficient sound pressure with respect to the input operating voltage is obtained and the heat dissipation property is also satisfactory can be realized.

As described above, the piezoelectric film in which the piezoelectric layer (polymer-based piezoelectric composite material) is sandwiched between the electrode layers and the protective layers are laminated thereon is output by vibration due to the application of a driving and generates heat by the vibration.

Therefore, it is preferable that the piezoelectric film has not only high thermoelectric conversion performance but also a satisfactory heat dissipation property. However, it cannot be said that the heat dissipation property of the piezoelectric film of the related art is sufficient.

On the contrary, in the piezoelectric film 10 according to the embodiment of the present invention, the lower electrode 16 has 2 to 40 projections 30 directed toward the lower protective layer 20 per visual field of 85 $\mu$m in the length direction of the electrode layer in the SEM image of the cross section.

With such a configuration, the piezoelectric film 10 according to the embodiment of the present invention can increase the surface area of the piezoelectric layer 12 and the lower electrode 16 (electrode layer) in close contact with the piezoelectric layer 12. Further, since the lower electrode 16 is typically made of a metal such as copper, the lower electrode 16 has high thermal conductivity. As a result, the piezoelectric film 10 according to the embodiment of the present invention has a high heat dissipation property and can suppress an increase in temperature even in a case where the piezoelectric film continuously vibrates and outputs a sound.

Further, as will be described later, the projections 30 of the lower electrode 16 can be formed, for example, by performing the calender treatment on the piezoelectric layer 12 a plurality of times in the production step of the piezoelectric film 10. That is, in the piezoelectric film 10 according to the embodiment of the present invention in which the lower electrode 16 has a plurality of projections 30, the density (volume fraction) of the piezoelectric particles 26 in the piezoelectric layer 12 is high. As a result, the piezoelectric film 10 according to the embodiment of the present invention can obtain a sufficient sound pressure with respect to the input operating voltage.

In the piezoelectric film 10 of the present invention, in a case where the number of the projections 30 per visual field of 85 $\mu$m in the length direction of the electrode layer in the SEM image of the cross section is less than two, the effect of having the projections 30 cannot be sufficiently obtained, and thus inconveniences such as an insufficient heat dissipation property and an insufficient sound pressure with respect to the input operating voltage occur.

In a case where the piezoelectric film 10 has a defect in the thin film electrode or the like, a white defect portion is generated as the piezoelectric film 10 is driven. In a case where the number of the projections 30 per visual field of 85 $\mu$m in the thickness direction of the electrode layer in the SEM image of the cross section is greater than 40, the number of white defective portions increases, which is disadvantageous in terms of the appearance and the like.

The number of the projections 30 per visual field of 85 $\mu$m in the thickness direction of the electrode layer in the SEM image of the cross section is preferably in a range of 2 to 35, more preferably in a range of 2 to 30, and still more preferably in a range of 2 to 25.

The height of the projection 30 is preferably 250 nm or less, more preferably 220 nm or less, and still more preferably 200 nm or less.

It is preferable that the height of the projection 30 is set to 250 nm or less from the viewpoint that generation of the white defect portion described above can be suppressed.

The height of the projection 30 is preferably 20 nm or greater as described above, and from the viewpoint of obtaining a more satisfactory heat dissipation property, the height thereof is more preferably 100 nm or greater, still more preferably 130 nm or greater, and particularly preferably 150 nm or greater.

The size of the projection 30, that is, the length of the reference line W is also not limited, but is preferably 2400 nm or less, more preferably 2000 nm or less, and still more preferably 1500 nm or less.

It is preferable that the size of the projection 30 is set to 2400 nm or less from the viewpoint that the generation of the white defect portion described above can be suppressed.

From the viewpoint of obtaining a satisfactory heat dissipation property, the size of the projection 30 is preferably 1000 nm or greater, more preferably 1200 nm or greater, and still more preferably 1300 nm or greater.

In the piezoelectric film 10 of the example illustrated in the figure, only the lower electrode 16 has the projections 30, but the present invention is not limited thereto. That is, in the piezoelectric film according to the embodiment of the present invention, both the lower electrode 16 and the upper electrode 14 may have the projections 30.

As described above, the terms "upper" and "lower" in the upper electrode 14 and the lower electrode 16 in the piezoelectric film 10 according to the embodiment of the present invention are provided based on the accompanying drawings for convenience in order to describe the piezoelectric film 10 according to the embodiment of the present invention. That is, the terms "upper" and "lower" in the piezoelectric film 10 according to the embodiment of the present invention have no technical meaning and are irrelevant to the actual use state. Therefore, the piezoelectric film according to the embodiment of the present invention may have a configuration in which only the upper electrode has the projections 30 and the lower electrode does not have projections, but even in this case, the substantial configuration is the same as that of the piezoelectric film of the example illustrated in the figure and the effects are also the same as described above.

Figs. 7 to 10 conceptually illustrate an example of the method of producing the piezoelectric film 10.

First, as conceptually illustrated in Fig. 7, a sheet-like material 34 in which the lower electrode 16 is formed on the lower protective layer 20 is prepared.

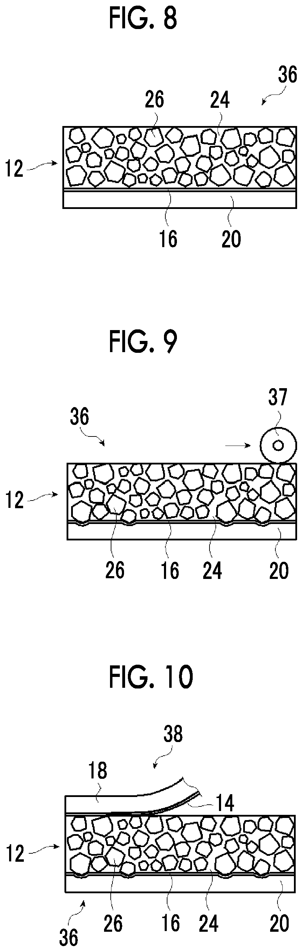

Further, as conceptually illustrated in Fig. 10, a sheet-like material 38 in which the upper electrode 14 is formed on the surface of the upper protective layer 18 is prepared.

The sheet-like material 34 may be prepared by forming a copper thin film or the like as the lower thin film electrode 16 on the surface of the lower protective layer 20 using vacuum vapor deposition, sputtering, plating, or the like. Similarly, the sheet-like material 38 may be prepared by forming a copper thin film or the like as the upper thin film electrode 14 on the surface of the upper protective layer 18 using vacuum vapor deposition, sputtering, plating, or the like.

Alternatively, a commercially available sheet-like material in which a copper thin film or the like is formed on a protective layer may be used as the sheet-like material 34 and/or the sheet-like material 38.

The sheet-like material 34 and the sheet-like material 38 may be exactly the same as or different from each other.

In a case where the protective layer is extremely thin and thus the handleability is degraded, a protective layer with a separator (temporary support) may be used as necessary. Further, a PET having a thickness of 25 μm to 100 μm or the like can be used as the separator. The separator may be removed after thermal compression bonding of the thin film electrode and the protective layer.

Next, as conceptually illustrated in Fig. 8, a laminate 36 obtained by laminating the sheet-like material 34 and the piezoelectric layer 12 is prepared by coating the lower electrode 16 of the sheet-like material 34 with a coating material (coating composition) that is the piezoelectric layer 12 and curing the material to form the piezoelectric layer 12.

First, the coating material is prepared by dissolving the polymer material in an organic solvent, adding the piezoelectric particles 26 such as PZT particles thereto, and stirring the solution.

The organic solvent is not limited, and various organic solvents such as dimethylformamide (DMF), methyl ethyl ketone, and cyclohexanone can be used.

In a case where the sheet-like material 34 is prepared and the coating material is prepared, the coating material is cast (applied) onto the sheet-like material 34, and the organic solvent is evaporated and dried. In this manner, as illustrated in Fig. 8, the laminate 36 in which the lower electrode 16 is provided on the lower protective layer 20 and the piezoelectric layer 12 is laminated on the lower electrode 16 is prepared.

A casting method of the coating material is not limited, and all known methods (coating devices) such as a bar coater, a slide coater, and a doctor knife can be used.

Alternatively, in a case where the polymer material is a material that can be heated and melted, the laminate 36 as illustrated in Fig. 8 may be prepared by heating and melting the polymer material to prepare a melt obtained by adding the piezoelectric particles 26 to the melted material, extruding the melt on the sheet-like material 34 illustrated in Fig. 7 in a sheet shape by carrying out extrusion molding or the like, and cooling the laminate.

As described above, in the piezoelectric film 10, a polymer piezoelectric material such as PVDF may be added to the polymer matrix 24 in addition to the polymer material having a viscoelasticity at room temperature.

In a case where the polymer piezoelectric material is added to the polymer matrix 24, the polymer piezoelectric material to be added to the coating material may be dissolved. Alternatively, the polymer piezoelectric material to be added may be added to the heated and melted polymer material having a viscoelasticity at room temperature so that the polymer piezoelectric material is heated and melted.

After the formation of the piezoelectric layer 12, the piezoelectric layer 12 is subjected to a calender treatment from the side opposite to the lower electrode 16 using a heating roller 37, as conceptually illustrated in Fig. 9.

In the production of a typical piezoelectric film, the calender treatment is performed once. On the contrary, in a case of the production of the piezoelectric film 10 according to the embodiment of the present invention, the calender treatment is performed a plurality of times.

As is well known, the calender treatment is a treatment in which the surface to be treated is pressed while being heated by a heating press, a heating roller, or the like to flatten the surface.

Here, by performing the calender treatment a plurality of times from the side opposite to the lower electrode 16, the projection 30 directed toward the lower protective layer 20 can be formed on the lower electrode 16 by pressing the lower electrode 16 with the piezoelectric particles 26. Further, by performing the calender treatment a plurality of times, the density (volume fraction) of the piezoelectric particles 26 in the piezoelectric layer 12 can be improved by heating and pressing the polymer matrix 24 constituting the piezoelectric layer 12. As a result, the piezoelectric film 10 according to the embodiment of the present invention can obtain a high sound pressure with respect to the input operating voltage.

The conditions such as the temperature and pressure of the calender treatment may be appropriately determined according to the material of the polymer matrix 24 of the piezoelectric layer 12, the amount of the piezoelectric particles 26 added to the coating material, and the like.

Further, the number of times of the calender treatment may be a plurality of times, but is preferably 3 times or more. By performing the calender treatment three times or more, the number of projections 30 per visual field of 85 μm in the length direction of the electrode layer of the SEM image can be suitably set to two or more.

The upper limit of the number of times of the calender treatments is not limited, but is preferably 50 times or less. By setting the number of times of the calender treatment to 50 times or less, it is possible to suitably prevent the number of projections 30 per visual field of 85 μm in the length direction of the electrode layer of the SEM image from exceeding 40.

Further, it is preferable that the calender treatment is performed before the polarization treatment of the piezoelectric layer 12 described below.

In a case where the calender treatment is performed, a large amount of the piezoelectric particles 26 are pushed into the piezoelectric layer 12. In this case, the piezoelectric particles 26 to be pushed into the layer along with rotation are also present. Therefore, in a case where the calender treatment is performed after the polarization treatment, the piezoelectric particles 26 whose polarization direction is inclined from the original film thickness direction are generated, and the piezoelectric characteristics of the piezoelectric film 10 are deteriorated. Further, such an inconvenience also occurs in a case of the thermal compression bonding of the sheet-like material 38 according to the thermal compression bonding described below.

On the contrary, by performing the polarization treatment after the calender treatment, deterioration of the piezoelectric characteristics due to the rotation of the piezoelectric particles 26 can be prevented. Further, since the calender treatment is performed once, the piezoelectric particles 26 are unlikely to rotate even in a case of the thermal compression bonding of the sheet-like material 38 according to the thermal compression bonding described below.

Next, the piezoelectric layer 12 of the laminate 36 in which the lower electrode 16 is provided on the lower protective layer 20 and the piezoelectric layer 12 is formed on the lower electrode 16 is subjected to the polarization treatment (poling). The polarization treatment of the piezoelectric layer 12 may be performed before the calender treatment, but it is preferable that the polarization treatment is performed after the calender treatment as described above.

The method of performing a polarization treatment on the piezoelectric layer 12 is not limited, and a known method can be used. For example, electric field poling in which a DC electric field is directly applied to a target to be subjected to the polarization treatment is exemplified. Further, in a case of performing electric field poling, the electric filed poling treatment may be performed using the upper electrode 14 and the lower electrode 16 by forming the upper electrode 14 before the polarization treatment.

Further, in a case where the piezoelectric film 10 according to the embodiment of the present invention is produced, the polarization treatment is performed in the thickness direction of the piezoelectric layer 12 (polymer-based piezoelectric composite material) instead of the plane direction.

Next, as illustrated in Fig. 10, the sheet-like material 38 that has been prepared in advance is laminated on the piezoelectric layer 12 side of the laminate 36 that has been subjected to the polarization treatment such that the upper electrode 14 is directed toward the piezoelectric layer 12.

Further, the piezoelectric film 10 according to the embodiment of the present invention as illustrate in Fig. 1 is prepared by performing thermal compression bonding on the laminate using a heating press device, heating rollers, or the like such that the laminate is sandwiched between the lower protective layer 20 and the upper protective layer 18 and bonding the laminate 36 and the sheet-like material 38 to each other.

Further, the piezoelectric film 10 according to the embodiment of the present invention may be prepared by bonding or preferably compression-bonding the laminate 36 and the sheet-like material 38 to each other using an adhesive.

The piezoelectric film 10 according to the embodiment of the present invention to be prepared in the above-described manner is polarized in the thickness direction instead of the plane direction, and thus excellent piezoelectric characteristics are obtained even in a case where the stretching treatment is not performed after the polarization treatment. Therefore, the piezoelectric film 10 according to the embodiment of the present invention has no in-plane anisotropy as a piezoelectric characteristic, and stretches and contracts isotropically in all directions in the in-plane direction in a case where a driving voltage is applied.

The piezoelectric film 10 according to the embodiment of the present invention may be produced using the cut sheet-like material 34 and the sheet-like material 38 and preferably using roll-to-roll (Roll to Roll). In the following description, roll-to-roll is also referred to as "RtoR" .

As is well known, RtoR is a production method of pulling out a long raw material from a roll around which the raw material is wound, performing various treatments such as film formation and a surface treatment while transporting the raw material in the longitudinal direction, and winding the treated raw material into a roll shape again.

In a case where the piezoelectric film 10 is produced using the above-described production method by RtoR, a first roll obtained by winding the long sheet-like material 34 and a second roll obtained by winding the long sheet-like material 38 are used.

The first roll and the second roll may be exactly the same.

The laminate 36 obtained by laminating the sheet-like material 34 and the piezoelectric layer 12 is prepared by pulling out the sheet-like material 34 from the first roll, coating the lower electrode 16 of the sheet-like material 34 with the coating material containing the polymer material and the piezoelectric particles 26 while the laminate is transported in the longitudinal direction, and drying the coating material by performing heating or the like to form the piezoelectric layer 12 on the lower electrode 16.

Next, the calender treatment is performed. Here, in a case where the piezoelectric film 10 is produced by RtoR, the calender treatment may be performed on the piezoelectric layer 12 a plurality of times by disposing a plurality of heating rollers 37 on the laminate 36 in the transport direction and performing the calender treatment using each heating roller 37 while the laminate 36 is transported.

Next, the piezoelectric layer 12 is subjected to the polarization treatment. Here, in a case where the piezoelectric film 10 is produced by RtoR, the polarization treatment is performed on the piezoelectric layer 12 by an electrode disposed in a state of extending in a direction orthogonal to the transport direction of the laminate 36 while the laminate 36 is transported. Before the polarization treatment, the calender treatment may be performed as described above. Further, the polarization treatment is performed on the piezoelectric layer 12 in the thickness direction of the piezoelectric layer 12.

Next, the sheet-like material 38 is pulled out from the second roll, and the sheet-like material 38 is laminated on the laminate 36 such that the upper thin film electrode 14 is directed toward the piezoelectric layer 12 according to a known method of using a bonding roller or the like while the sheet-like material 38 and the laminate 36 are transported.

Thereafter, the laminate 36 and the sheet-like material 38 are sandwiched and transported by a pair of heating rollers to be subjected to thermal compression bonding to complete the piezoelectric film 10 according to the embodiment of the present invention, and the piezoelectric film 10 is wound in a roll shape.

In the above-described example, the piezoelectric film 10 according to the embodiment of the present invention is prepared by transporting the sheet-like material (laminate) only once in the longitudinal direction by RtoR, but the present invention is not limited thereto.

For example, the laminate is formed and subjected to the polarization treatment, and the laminate 36 is wound once into a roll shape to obtain a laminate roll. Next, the laminate 36 is pulled out from the laminate roll, the sheet-like material 38 is laminated and subjected to thermal compression bonding as described above while the laminate is transported in the longitudinal direction to prepare the piezoelectric film 10, and the piezoelectric film 10 may be wound into a roll shape.

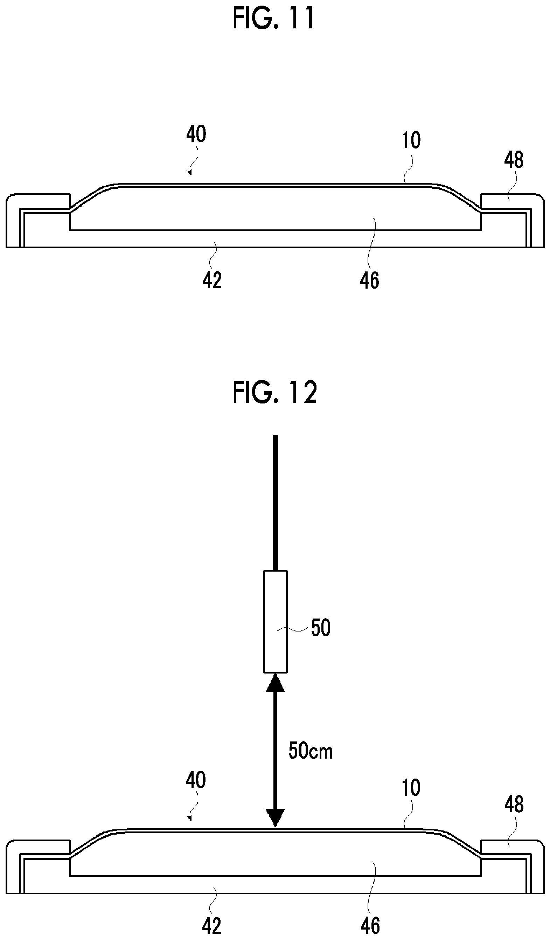

Fig. 11 is a conceptual view illustrating an example of a flat plate type piezoelectric speaker including the piezoelectric film 10 according to the embodiment of the present invention.

The piezoelectric speaker 40 is a flat plate type piezoelectric speaker that uses the piezoelectric film 10 according to the embodiment of the present invention as a vibration plate that converts an electrical signal into vibration energy. Further, the piezoelectric speaker 40 can also be used as a microphone, a sensor, or the like.

The piezoelectric speaker 40 is configured to have the piezoelectric film 10, a case 42, a viscoelastic support 46, and a frame 48.

The case 42 is a thin housing formed of plastic or the like and having one surface that is open. Examples of the shape of the housing include a rectangular parallelepiped shape, a cubic shape, and a cylindrical shape.

Further, the frame 48 is a frame material that has, in the center thereof, a through hole having the same shape as the open surface of the case 42 and engages with the open surface side of the case 42.

The viscoelastic support 46 is a support used for efficiently converting the stretch and contraction movement of the piezoelectric film 10 into a forward and rearward movement (a movement in the direction perpendicular to the surface of the film) by means of having moderate viscosity and elasticity, supporting the piezoelectric film 10, and applying a constant mechanical bias to any place of the piezoelectric film. Examples of the viscoelastic support 46 include wool felt, nonwoven fabric such as wool felt containing PET, and glass wool.

The piezoelectric speaker 40 is configured by accommodating the viscoelastic support 46 in the case 42, covering the case 42 and the viscoelastic support 46 with the piezoelectric film 10, and fixing the frame 48 to the case 42 in a state of pressing the periphery of the piezoelectric film 10 against the upper end surface of the case 42 by the frame 48.

Here, in the piezoelectric speaker 40, the viscoelastic support 46 has a shape in which the height (thickness) is larger than the height of the inner surface of the case 42.

Therefore, in the piezoelectric speaker 40, the viscoelastic support 46 is held in a state of being thinned by being pressed downward by the piezoelectric film 10 at the peripheral portion of the viscoelastic support 46. Similarly, in the peripheral portion of the viscoelastic support 46, the curvature of the piezoelectric film 10 suddenly fluctuates, and a rising portion that decreases in height toward the periphery of the viscoelastic support 46 is formed in the piezoelectric film 10. Further, the central region of the piezoelectric film 10 is pressed by the viscoelastic support 46 having a square columnar shape and has a (approximately) planar shape.

In the piezoelectric speaker 40, in a case where the piezoelectric film 10 is stretched in the in-plane direction due to the application of a driving voltage to the lower electrode 16 and the upper electrode 14, the rising portion of the piezoelectric film 10 changes the angle in a rising direction due to the action of the viscoelastic support 46 in order to absorb the stretched part. As a result, the piezoelectric film 10 having the planar portion moves upward.

On the contrary, in a case where the piezoelectric film 10 contracts in the in-plane direction due to the application of the driving voltage to the lower electrode 16 and the upper electrode 14, the rising portion of the piezoelectric film 10 changes the angle in a falling direction (a direction approaching the flat surface) in order to absorb the contracted part. As a result, the piezoelectric film 10 having the planar portion moves downward.

The piezoelectric speaker 40 generates a sound by the vibration of the piezoelectric film 10.

In the piezoelectric film 10 according to the embodiment of the present invention, the conversion from the stretching and contracting movement to vibration can also be achieved by holding the piezoelectric film 10 in a curved state.

Therefore, the piezoelectric film 10 according to the embodiment of the present invention can function as a piezoelectric speaker having flexibility by being simply maintained in a curved state instead of the piezoelectric speaker 40 having rigidity in a flat plate shape, as illustrated in Fig. 11.

The piezoelectric speaker formed of the piezoelectric film 10 according to the embodiment of the present invention can be stored in a bag or the like by, for example, being rolled or folded using the excellent flexibility. Therefore, with the piezoelectric film 10 according to the embodiment of the present invention, a piezoelectric speaker that can be easily carried even in a case where the piezoelectric speaker has a certain size can be realized.

Further, as described above, the piezoelectric film 10 according to the embodiment of the present invention has excellent elasticity and excellent flexibility, and has no in-plane anisotropy as a piezoelectric characteristic. Therefore, in the piezoelectric film 10 according to the embodiment of the present invention, a change in acoustic quality regardless of the direction in which the film is bent is small, and a change in acoustic quality with respect to the change in curvature is also small. Accordingly, the piezoelectric speaker formed of the piezoelectric film 10 according to the embodiment of the present invention has a high degree of freedom of the installation place and can be attached to various products as described above. For example, a so-called wearable speaker can be realized by attaching the piezoelectric film 10 according to the embodiment of the present invention to clothing such as a suit and portable items such as a bag in a curved state.

Further, as described above, the piezoelectric film according to the embodiment of the present invention can be used for a speaker of a display device by bonding the piezoelectric film to a display device having flexibility such as an organic EL display device having flexibility or a liquid crystal display device having flexibility.

As described above, the piezoelectric film 10 according to the embodiment of the present invention stretches and contracts in the plane direction in a case where a voltage is applied, and vibrates suitably in the thickness direction due to the stretch and contraction in the plane direction, and thus a sound with a high sound pressure can be output and excellent acoustic characteristics are exhibited in a case where the piezoelectric film 10 is used for a piezoelectric speaker or the like.

The piezoelectric film 10 according to the embodiment of the present invention, which exhibits excellent acoustic characteristics, that is, high stretch and contraction performance due to piezoelectricity is satisfactorily operated as a piezoelectric vibrating element that vibrates a vibration body such as a vibration plate by laminating a plurality of the piezoelectric films. Since the piezoelectric film 10 according to the embodiment of the present invention has a satisfactory heat dissipation property, heat generation of the film can be prevented even in a case of being laminated and formed into a piezoelectric vibrator, and thus heating of the vibration plate can be prevented.

Further, in a case of lamination of the piezoelectric films 10, each piezoelectric film may not have the upper protective layer 18 and/or the lower protective layer 20 unless there is a possibility of a short circuit. Alternatively, the piezoelectric film that does not have the upper protective layer 18 and/or the lower protective layer 20 may be laminated through an insulating layer.

As an example, a speaker in which a laminate of the piezoelectric films 10 is bonded to the vibration plate and the vibration plate is vibrated by the laminate of the piezoelectric films 10 to output a sound may be used. That is, in this case, the laminate of the piezoelectric film 10 acts as a so-called exciter that outputs a sound by vibrating the vibration plate.

By applying a driving voltage to the laminated piezoelectric films 10, each piezoelectric film 10 stretches and contracts in the plane direction, and the entire laminate of the piezoelectric film 10 stretches and contracts in the plane direction due to the stretch and contraction of each piezoelectric film 10. The vibration plate to which the laminate has been attached is bent due to the stretch and contraction of the laminate of the piezoelectric film 10 in the plane direction, and thus the vibration plate vibrates in the thickness direction. The vibration plate generates a sound using the vibration in the thickness direction. The vibration plate vibrates according to the magnitude of the driving voltage applied to the piezoelectric film 10 and generates a sound according to the driving voltage applied to the piezoelectric film 10.

Therefore, the piezoelectric film 10 itself does not output sound in this case.

Therefore, even in a case where the rigidity of each piezoelectric film 10 is low and the stretching and contracting force thereof is small, the rigidity is increased by laminating the piezoelectric films 10, and the stretching and contracting force as the entire laminate is increased. As a result, in the laminate of the piezoelectric films 10, even in a case where the vibration plate has a certain degree of rigidity, the vibration plate is sufficiently bent with a large force and the vibration plate can be sufficiently vibrated in the thickness direction, whereby the vibration plate can generate a sound.

In the laminate of the piezoelectric film 10, the number of laminated piezoelectric films 10 is not limited, and the number of sheets set such that a sufficient amount of vibration is obtained may be appropriately set according to, for example, the rigidity of the vibration plate to be vibrated.

Further, one piezoelectric film 10 according to embodiment of the present invention can also be used as a similar exciter (piezoelectric vibrating element) in a case where the piezoelectric film has a sufficient stretching and contracting force.

The vibration plate vibrated by the laminate of the piezoelectric film 10 according to the embodiment of the present invention is not limited, and various sheet-like materials (such as plate-like materials and films) can be used.

Examples thereof include a resin film consisting of polyethylene terephthalate (PET) and the like, foamed plastic consisting of foamed polystyrene and the like, a paper material such as a corrugated cardboard material, a glass plate, and wood. Further, a device such as a display device may be used as the vibration plate in a case where the device can be sufficiently bent.

It is preferable that the laminate of the piezoelectric film 10 according to the embodiment of the present invention is obtained by bonding adjacent piezoelectric films with a bonding layer (bonding agent). Further, it is preferable that the laminate of the piezoelectric film 10 and the vibration plate are also bonded to each other with a bonding layer.

The bonding layer is not limited, and various layers that can bond materials to be bonded can be used. Therefore, the bonding layer may consist of a pressure sensitive adhesive or an adhesive. It is preferable that an adhesive layer consisting of an adhesive is used from the viewpoint that a solid and hard bonding layer is obtained after the bonding.

The same applies to the laminate formed by folding back the long piezoelectric film 10 described later.

In the laminate of the piezoelectric films 10, the polarization direction of each piezoelectric film 10 to be laminated is not limited. As described above, the polarization direction of the piezoelectric film 10 according to the embodiment of the present invention is the polarization direction in the thickness direction.

Therefore, in the laminate of the piezoelectric films 10, the polarization directions may be the same for all the piezoelectric films 10, and piezoelectric films having different polarization directions may be present.

Here, in the laminate of the piezoelectric films 10, it is preferable that the piezoelectric films 10 are laminated such that the polarization directions of the adjacent piezoelectric films 10 are opposite to each other.

In the piezoelectric film 10, the polarity of the voltage to be applied to the piezoelectric layer 12 depends on the polarization direction. Therefore, even in a case where the polarization direction is directed from the upper electrode 14 toward the lower electrode 16 or from the lower electrode 16 toward the upper electrode 14, the polarity of the upper electrode 14 and the polarity of the lower electrode 16 in all the piezoelectric films 10 to be laminated are set to be the same polarity.

Therefore, by reversing the polarization directions of the adjacent piezoelectric films 10, even in a case where the thin film electrodes of the adjacent piezoelectric films 10 come into contact with each other, the thin film electrodes in contact with each other have the same polarity, and thus there is no risk of a short circuit.

The laminate of the piezoelectric film 10 may be configured such that a long piezoelectric film 10 is folded back, for example, once or more times, or preferably a plurality of times to laminate a plurality of layers of the piezoelectric films 10.

The structure in which the long piezoelectric film 10 is folded back and laminated has the following advantages.

That is, in the laminate in which a plurality of cut sheet-like piezoelectric films 10 are laminated, the upper electrode 14 and the lower electrode 16 need to be connected to a driving power source for each piezoelectric film. On the contrary, in the configuration in which the long piezoelectric film 10 is folded back and laminated, only one sheet of the long piezoelectric film 10 can form the laminate. Further, in the configuration in which the long piezoelectric film 10 is folded back and laminated, only one power source is required for applying the driving voltage, and the electrode may be pulled out from the piezoelectric film 10 at one place.

Further, in the configuration in which the long piezoelectric film 10 is folded back and laminated, the polarization directions of the adjacent piezoelectric films 10 are inevitably opposite to each other.

Hereinbefore, the piezoelectric film according to the embodiment of the present invention have been described in detail, but the present invention is not limited to the above-described examples, and various improvements or modifications may be made within a range not departing from the scope of the present invention.

Examples

Hereinafter, the present invention will be described in more detail with reference to specific examples of the present invention. Further, the present invention is not limited to the examples, and the materials, the used amounts, the proportions, the treatment contents, the treatment procedures, and the like shown in the following examples can be appropriately changed within a range not departing from the scope of the present invention.

[Example 1]

A piezoelectric film was prepared by the method illustrated in Figs. 7 to 10.

First, cyanoethylated PVA (CR-V, manufactured by Shin-Etsu Chemical Co., Ltd.) was dissolved in methyl ethyl ketone (MEK) at the following compositional ratio. Thereafter, PZT particles serving as the piezoelectric particles were added to the solution at the following compositional ratio, and the solution was stirred using a propeller mixer (rotation speed of 2000 rpm), thereby preparing a coating material for forming a piezoelectric layer.

- PZT Particles: 300 parts by mass
- Cyanoethylated PVA: 30 parts by mass
- DMF: 70 parts by mass

Further, PZT particles obtained by sintering mixed powder, formed by wet-mixing powder of a Pb oxide, a Zr oxide, and a Ti oxide as the main components such that the amount of Zr and the amount of Ti respectively reached 0.52 moles and 0.48 moles with respect to 1 mole of Pb using a ball mill, at 800°C for 5 hours and being subjected to a crushing treatment were used as the PZT particles.

A sheet-like material obtained by performing vacuum vapor deposition on a copper thin film having a thickness of 0.1 $\mu$m was prepared on a PET film having a thickness of 4 $\mu$m. That is, in the present example, the upper electrode and the lower electrode are copper-deposited thin films having a thickness of 0.1 m, and the upper protective layer and the lower protective layer are PET films having a thickness of 4 $\mu$m.

The lower electrode (copper-deposited thin film) of the sheet-like material was coated with the coating material for forming the piezoelectric layer prepared in advance using a slide coater. Further, the lower electrode was coated such that the film thickness of the coating film after being dried reached 40 $\mu$m.

Next, the material obtained by coating the sheet-like material with the coating material was heated and dried on a hot plate at 120°C to evaporate DMF. In this manner, a laminate in which the lower thin film electrode made of copper was provided on the lower protective layer made of PET and the piezoelectric layer having a thickness of 40 $\mu$m was formed thereon was prepared.

Next, as shown in Fig. 9, the calender treatment was performed three times on the upper surface (the surface on a side opposite to the lower electrode) of the piezoelectric layer of the prepared laminate using a heating roller.

The calender treatment was performed by setting the temperature of the heating roller to 70°C, the pressing force of the heating roller to 0.3 MPa, and the moving speed of the heating roller to 0.6 m/min.

The piezoelectric layer on which the calender treatment had been performed was subjected to the polarization treatment in the thickness direction.

The sheet-like material was laminated on the laminate which had been subjected to the polarization treatment in a state where the upper electrode (copper thin film side) was directed toward the piezoelectric layer.

Next, the piezoelectric film as illustrated in Fig. 1 was prepared by performing thermal compression bonding on the laminate of the laminate and the sheet-like material at a temperature of 120°C using a laminator device, and bonding and adhering the piezoelectric layer and the upper electrode to each other.

The prepared piezoelectric film was bonded to a support made of a flat resin film having a thickness of 5 $\mu$m with an adhesive.

Next, the laminate of the piezoelectric film and the support was cut with a cross-section ion milling device (IM4000PLUS, manufactured by Hitachi High-Tech Corporation).

Further, in a case where the laminate was cut with the cross-section ion milling device, the cross section of the laminate was processed at any position on the cross section by approximately 1000 $\mu$m in the length direction of the electrode layer.

Further, the cross section of the laminate was subjected to Os coating to have a thickness of approximately 2 nm.

The region where the cross section of the laminate was processed was captured by a SEM (SM-09010, manufactured by JEOL Ltd.), and the number of projections of the lower electrode in the region of a visual field of 85 $\mu$m in the length direction of the electrode layer which was arbitrarily selected in the captured cross-sectional SEM image was counted. The SEM observation was performed at a magnification of 1500 times such that the lower electrode and the lower protective layer were able to fit in one screen under the conditions of acquiring a reflected electron composition image at an acceleration voltage of 2.0 kV.

The counting of the number of projections was performed on any ten cross sections of the piezoelectric film, and the average value of the number of projections counted on the ten cross sections was defined as the number of projections of the lower electrode per visual field of 85 $\mu$m in the length direction of the electrode layer in the SEM image in the prepared piezoelectric film.

As a result, the number of projections of the lower electrode was three.

Further, the cross-sectional SEM image was enlarged at a magnification of 40000 times for each projection, the reference line and the perpendicular line of the projection were set by the above-described method, and the size and the height of the projection were measured.

As a result, the size of the largest projection (the maximum value of the size) was 1000 nm, and the height of the highest projection (the maximum value of the height) was 100 nm.

Further, the number of projections having a height of 20 nm or greater was two per visual field of 85 $\mu$m in the length direction of the electrode layer of the SEM image. Further, the number of projections having a height of 20 nm or greater is also an average value in a visual field of 85 $\mu$m in the length direction of the electrode layer in the ten cross sections in which the number of projections was initially counted.

[Examples 2 to 4 and Comparative Examples 1 to 3]

Piezoelectric films were prepared in the same manner as in Example 1 except that the calender treatment was performed 10 times (Example 2), 20 times (Example 3), 40 times (Example 4), 0 times (Comparative Example 1), one time (Comparative Example 2), and 50 times (Comparative Example 3).

The number of projections per visual field of 85 μm in the length direction of the electrode layer in the SEM image of each of the prepared piezoelectric films was counted, the size and the height of the projections were measured, and the size of the largest projection and the height of the highest projection, and the number of projections in which the height per visual field of 85 μm in the length direction of the electrode layer in the SEM image was 20 nm or greater were measured in the same manner as in Example 1.

[Preparation of piezoelectric speaker and measurement of sound pressure]

The piezoelectric speakers illustrated in Fig. 11 were prepared using the prepared piezoelectric films.

First, a rectangular test piece having a size of 210 × 300 mm (A4 size) was cut out from the prepared piezoelectric film. The cut-out piezoelectric film was placed on a 210 × 300 mm case in which glass wool serving as a viscoelastic support was stored in advance as illustrated in Fig. 11, and the peripheral portion was pressed by a frame to impart an appropriate tension and an appropriate curvature to the piezoelectric film, thereby preparing a piezoelectric speaker as illustrated in Fig. 11.

The depth of the case was set to 9 mm, the density of glass wool was set to 32 kg/m$^3$, and the thickness before assembly was set to 25 mm.

A 1 kHz sine wave was input to the prepared piezoelectric speaker as an input signal through a power amplifier, and the sound pressure was measured with a microphone 50 placed at a distance of 50 cm from the center of the speaker as illustrated in Fig. 12. Further, the measured value of the sound pressure is shown as a difference from Comparative Example 2 with Comparative Example 2 as a reference (Ref).

[Heat dissipation property test]

The prepared piezoelectric speaker was driven at a predetermined volume for 5 minutes, and the temperature of the piezoelectric film was measured by thermography.

A case where the temperature of the piezoelectric film did not rise above 30°C was evaluated as "OK" while driving of the piezoelectric speaker for 5 minutes, and a case where the temperature rose above 30°C even for a moment was evaluated as "NG".

[Durability test]

A driving voltage having an average sound pressure of 80 dB at a position separated by 1 m from the prepared piezoelectric speaker was applied to the piezoelectric film for 1000 hours to drive the piezoelectric speaker.

Thereafter, the surface of the piezoelectric film was visually observed to confirm the presence or absence of white defect portions.

A case where white defect portions were not found was evaluated as "none" and a case where even one white defect portion was found was evaluated as "yes".

The results are listed in the table below.

[Table 1]

| | Comparative Example 1 | Comparative Example 1 | Comparative Example 1 | Example 1 | Example 2 | Example 3 | Example 4 |
|---|---|---|---|---|---|---|---|
| Number of times of calender treatment | 0 times | 1 time | 50 times | 3 times | 10 times | 20 times | 40 times |
| Number of projections of lower electrode | 0 | 1 | 55 | 3 | 21 | 36 | 40 |
| Number of projections having height of 20 nm | - | 0 | 50 | 2 | 17 | 26 | 36 |
| Maximum value of size of projection | - | 500 nm | 3000 nm | 1000 nm | 2200 nm | 1500 nm | 2400 nm |
| Maximum value of height of projection | - | 50 nm | 300 nm | 100 nm | 150 nm | 130 nm | 250 nm |
| Sound pressure | -1.0 dB | Ref | -3.0 dB | 2.0 dB | 3.0 dB | 4.0 dB | 1.5 dB |
| Heat dissipation property test | NG | NG | OK | OK | OK | OK | OK |
| Durability test | Not performed | Not performed | Performed | Not performed | Not performed | Not performed | Not performed |

As shown in the table, in the piezoelectric speaker formed of the piezoelectric film according to the embodiment of the present invention in which the lower electrode had 2 to 40 projections per visual field of 85 $\mu$m in the length direction of the electrode layer in the SEM image of the cross section, a high sound pressure was obtained and the heat dissipation property and the heat resistance were also satisfactory.

On the contrary, in Comparative Example 1 in which the lower electrode did not have a projection and Comparative Example 2 in which the number of projections of the lower electrode was less than the range of the present invention, the durability was not problematic, but the heat dissipation property was degraded. Further, in Comparative Example 3 in which the number of projections of the lower electrode was greater than the range of the present invention, the heat dissipation property was excellent, but white defect portions were generated in the heat resistance test. In addition, the sound pressure was low in the comparative examples as compared with the product of the present invention.

Further, in Comparative Example 1 in which the calender treatment was not performed, the presence or absence of the projections was confirmed by similarly performing observation even on the upper electrode side with a SEM. As a result, in Comparative Example 1, projections directed toward the upper protective layer were not confirmed not only in the lower electrode but also in the upper electrode.

As shown in the results described above, the effects of the present invention are apparent.

Explanation of References

10: piezoelectric film
12: piezoelectric layer
14: upper (thin film) electrode
16: lower (thin film) electrode
18: upper protective layer
20: lower protective layer
24: polymer matrix
26: piezoelectric particle
30: projection
34, 38: sheet-like material
36: laminate
37: heating roller
40: piezoelectric speaker
42: case
46: viscoelastic support
48: frame
50: microphone

**Claims**

1. A piezoelectric film comprising:

   a polymer-based piezoelectric composite material which contains piezoelectric particles in a matrix containing a polymer material;
   electrode layers which are provided on both surfaces of the polymer-based piezoelectric composite material; and
   a protective layer provided on a surface of at least one electrode layer,
   wherein in a case where a cross section of the piezoelectric film is observed with a scanning electron microscope, at least one electrode layer has a plurality of projections directed toward the protective layer, and the number of projections is in a range of 2 to 40 per visual field of 85 $\mu$m of the scanning electron microscope in a length direction of the electrode layer in the cross section.

2. The piezoelectric film according to claim 1,
   wherein the projection at an interface between the protective layer and the electrode layer has a height of 250 nm or less.

3. The piezoelectric film according to claim 1 or 2,
   wherein the projection at an interface between the protective layer and the electrode layer has a size of 2400 nm or less.

4. The piezoelectric film according to any one of claims 1 to 3,
   wherein the protective layers are provided on surfaces of both the electrode layers.

5. The piezoelectric film according to any one of claims 1 to 4,
   wherein the piezoelectric film is polarized in a thickness direction.

6. The piezoelectric film according to any one of claims 1 to 5,
   wherein the piezoelectric film has no in-plane anisotropy as a piezoelectric characteristic.

7. The piezoelectric film according to any one of claims 1 to 6,
   wherein the polymer material contains a cyanoethyl group.

8. The piezoelectric film according to claim 7,
   wherein the polymer material is cyanoethylated polyvinyl alcohol.

9. The piezoelectric film according to any one of claims 1 to 8,
   wherein the piezoelectric particles consist of ceramic particles having a perovskite-type or wurtzite-type crystal structure.

# FIG. 1

# FIG. 2

## FIG. 3

## FIG. 4

## FIG. 5

## FIG. 6

## FIG. 7

# FIG. 8

# FIG. 9

# FIG. 10

## FIG. 11

## FIG. 12

<table>
<tr><td colspan="2">**INTERNATIONAL SEARCH REPORT**</td><td>International application No.<br>PCT/JP2020/019872</td></tr>
</table>

**A. CLASSIFICATION OF SUBJECT MATTER**
Int. Cl. H01L41/18(2006.01)i, H01L41/047(2006.01)i, H01L41/053(2006.01)i,
H01L41/33(2013.01)i, H04R17/00(2006.01)i
FI: H01L41/18, H01L41/047, H01L41/053, H01L41/33, H04R17/00
According to International Patent Classification (IPC) or to both national classification and IPC

**B. FIELDS SEARCHED**

Minimum documentation searched (classification system followed by classification symbols)
Int. Cl. H01L41/18, H01L41/047, H01L41/053, H01L41/33, H04R17/00

Documentation searched other than minimum documentation to the extent that such documents are included in the fields searched
Published examined utility model applications of Japan    1922-1996
Published unexamined utility model applications of Japan    1971-2020
Registered utility model specifications of Japan    1996-2020
Published registered utility model applications of Japan    1994-2020

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2014/162976 A1 (FUJIFILM CORP.) 09 October 2014, paragraphs [0001], [0007], [0020]-[0119], fig. 1 (A), 1 (C), 2 | 1-9 |
| A | JP 2013-171981 A (NGK INSULATORS, LTD.) 02 September 2013, entire text, all drawings | 1-9 |
| A | JP 2001-85757 A (MATSUSHITA ELECTRIC INDUSTRIAL CO., LTD.) 30 March 2001, entire text, all drawings | 1-9 |

☐ Further documents are listed in the continuation of Box C.　　☒ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>22.07.2020 | Date of mailing of the international search report<br>04.08.2020 |
|---|---|
| Name and mailing address of the ISA/<br>　　Japan Patent Office<br>　　3-4-3, Kasumigaseki, Chiyoda-ku,<br>　　Tokyo 100-8915, Japan | Authorized officer<br><br>Telephone No. |

Form PCT/ISA/210 (second sheet) (January 2015)

**INTERNATIONAL SEARCH REPORT**

Information on patent family members

International application No.

PCT/JP2020/019872

| Patent Documents referred to in the Report | Publication Date | Patent Family | Publication Date |
|---|---|---|---|
| WO 2014/162976 A1 | 09.10.2014 | US 2016/0014526 A1 paragraphs [0002], [0009], [0042]-[0272], fig. 1A, 1C, 2A-2F<br>JP 2014-212307 A<br>KR 10-2015-0124986 A | |
| JP 2013-171981 A | 02.09.2013 | US 2013/0214647 A1 entire text, all drawings<br>EP 2631959 A2<br>CN 103258951 A | |
| JP 2001-85757 A | 30.03.2001 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2014212307 A